# EUROPEAN PATENT SPECIFICATION

(11) **EP 1 034 983 B1**
(45) Date of publication and mention of the grant of the patent: **13.08.2003**
(21) Application number: 00105085.5
(22) Date of filing: 10.03.2000
(51) Int. Cl.: B60R 16/02, H01R 9/24, H01R 13/703, H05K 1/18

(54) **Branch connection box**
Abzweigverbindergehäuse
Boîtier de connexion

(30) Priority: 12.03.1999 JP 6700899
(43) Date of publication of application: 13.09.2000
(73) Proprietor: AUTONETWORKS TECHNOLOGIES, LTD., Nagoya-shi, Aichi (JP); SUMITOMO WIRING SYSTEMS, Ltd., Yokkaichi-shi, Mie-ken 510 (JP); SUMITOMO ELECTRIC INDUSTRIES, LTD., Osaka-shi, Osaka (JP)
(72) Inventor: Sumida, Yoshitaka, Harness System Techn. Res. Ltd., Nagoya-shi, Aichi (JP)
(74) Representative: Kuhnen & Wacker

(56) References cited:
- EP-A- 1 026 783
- DE-A- 3 936 906
- US-A- 4 703 397
- US-A- 5 011 417

## Description

### BACKGROUND OF THE INVENTION

### 1. Field of the Invention

The present invention relates to a branch connection box according to claim 1 and claim 5.

### 2. Description of the Related Art

From DE 39 36 906 A a connection box is known, which comprises a case in which a circuit board is fixedly accommodated. A plurality of connector terminals are fixedly mounted to the case and the connector terminals have respective one ends thereof positioned outside the case and respective other ends thereof disposed inside the case. The respective other ends of the connector terminals are fixedly secured to the circuit board. Moreover, this known connection box comprises also deflection prevention means for preventing the deflection of the case generated upon inserting an external connector terminal into the connector terminals under pressure, wherein the deflection prevention means is integrally formed with the case.

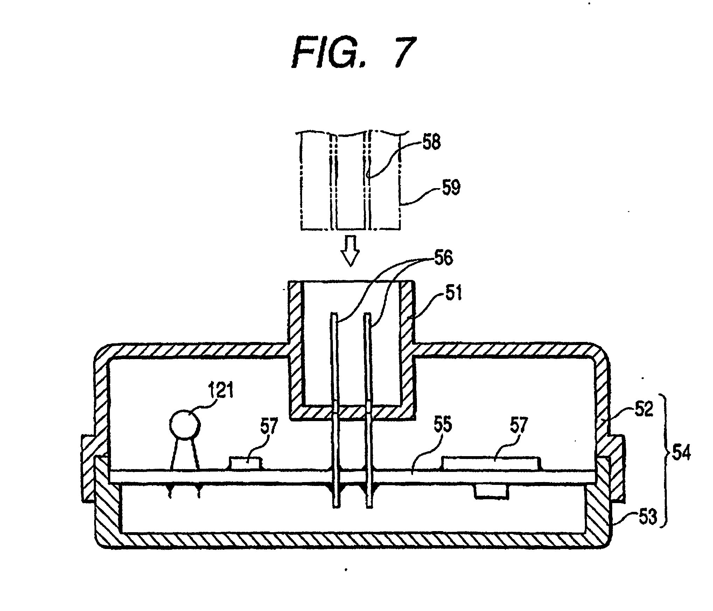

Conventionally, as shown in Fig. 7, this kind of branch connection box includes a case 54 made of resilient material such as synthetic resin or the like which is composed of an upper case 52 on which a connector housing 51 is integrally formed and a lower case 53, a circuit board 55 such as a print wiring board or the like made of resilient material such as synthetic resin which is accommodated in this case 54 such that the peripheral portion of the circuit board 55 is supported by the lower case 53, and a plurality of male connector terminals 56 which are fixedly mounted such that they have one end sides thereof positioned outside the case 54 in the inside of the connector housing 51 and the other end sides thereof positioned in the inside of the case 54 and have the other ends thereof fixedly secured to lands of the circuit board 55 by soldering or the like. A plurality of electronic components 57 are mounted on the circuit board 55 thus constituting a given electronic circuit.

The branch connection box having such a constitution is provided for the branch connection of wire harness of an automobile, for example, wherein an external connector 59 provided with a female connector terminal 58 is inserted in the connector housing 51 and then the female connector terminal 58 is inserted into the male connector terminals 56 under pressure so as to establish the electrical connection between them.

By the way, in the above-mentioned conventional branch connection box, when the female connector terminal 58 of the external connector 59 is inserted into the male connector terminals 56 under pressure, the upper case 52 is pressed toward the circuit board 55 side and is held in a deflected condition and hence, a pressing force is applied to the circuit board 55 by the connector terminals 56. Accordingly, the circuit board 55 is deflected and a stress is generated at portions where the connector terminals 56 are fixedly secured to the circuit board 55 and hence, problems such that cracks occur at the fixedly securing portion, the lands are peeled off to cause a disconnection and the like are liable to occur. Further, when the circuit board 55 is deflected, the problems such that the electrical connection of the electronic components 57 mounted on the circuit board 55 with the circuit board 55 is disconnected, in case the electronic components 57 are fragile, the electronic components 57 per se are ruptured and the like are liable to occur.

To solve these problems, as described in Japanese Laid-Open Patent Publication 9-186475, it is considered to extend the distal ends of the connector terminals 56 so as to bring the distal ends into contact with the lower case 53. However, because of the irregularities of the mounting positions of the connector terminals 56 in an axial direction, there are cases where the distal ends of the connector terminals 56 are not brought into contact with the lower case 53. In such cases, the task cannot be solved.

### SUMMARY OF THE INVENTION

The present invention has been made in view of the above and it is an object of the present invention to provide a branch connection box, which can assuredly prevent the deflection of a case, which occurs when an external connector terminal is inserted into connector terminals.

According to a first inventive solution this object is solved by the features of claim 1. Improved embodiments of the first inventive solution result from the subclaims 2 to 4.

A second inventive solution of the above object results from claim 5. An improved embodiment of the second inventive solution results from claim 6. Thus, there is provided a branch connection box where a plurality of connector terminals are fixedly mounted to a case in which a circuit board is fixedly accommodated such that the connector terminals have respective one end sides thereof positioned outside the case and respective other end sides thereof disposed inside the case and respective other ends of the connector terminals are fixedly secured to the circuit board, wherein deflection prevention means for preventing the deflection of the case generated upon inserting an external connector terminal into the connector terminals under pressure is integrally formed with the case.

Due to such a constitution, even if the case is pressed toward the circuit board side at the time of inserting the connector terminal of the external connector into a plurality of connector terminals fixedly secured to the case under pressure, the deflection of the case can be prevented by the deflection prevention means integrally formed on the case. In this manner, since the circuit board is not deflected, no stress is generated at the portions where the connector terminals are connected to the circuit board and hence, problems such that cracks occur at the fixedly securing portions or the lands are peeled off so as to cause a disconnection can be effectively prevented. Further, since the circuit board is not deflected, problems such that the electrical connection of the electronic components to the circuit board is disconnected or the electronic components per se are ruptured can be effectively prevented.

According to an aspect of the invention, in the branch connection box, the case is comprised of a first case member and a second case member, the connector terminals are fixedly mounted on the first case member, the circuit board is accommodated in the case such that one surface of the circuit board faces the first case member in an opposed manner and the other surface of the circuit board faces the second case member in an opposed manner.

Due to such a constitution, the case can be easily constructed by combining the first case member and the second case member with each other, and the connector can be easily constructed by fixedly securing the connector terminals to the first case member. Further, since the circuit board is accommodated in the case such that one surface of the circuit board faces the first case member in an opposed manner while the other surface of the circuit board faces the second case member in an opposed manner, the circuit board can be easily accommodated in the case.

According to the invention, in the branch connection box, the deflection prevention means is comprised of a plurality of protrusions formed on the second case member such that the protrusions are brought into contact with the other surface of the circuit board.

The deflection prevention means further includes a plurality of second protrusions integrally formed on the first case member such that the second protrusions are brought into contact with one surface of the circuit board in addition to the plurality of first protrusions formed on the second case member.

Due to such a constitution, even if the case is pressed toward the circuit board side, the circuit board is brought into contact with the first protrusions integrally formed on the second case member and hence, the circuit board is not deflected, and further, the second protrusions integrally formed on the first case member are brought into contact with the circuit board and hence, the deflection of the case can be further assuredly prevented.

A plurality of protrusions are formed such that the protrusions are brought into contact with the circuit board at positions adjacent to portions where the connector terminals are fixedly secured to the circuit board.

Due to such a constitution, even if the case is pressed to the circuit board side, the circuit board is brought into contact with the protrusions integrally formed on the second case member at positions adjacent to the portion where the connector terminals are fixedly secured to the circuit board and hence, the circuit board is assuredly prevented form deformation resulting in the effective prevention of the deflection of the case.

A plurality of second protrusions are formed such that the second protrusions respectively face a plurality of first protrusions in an opposed manner by way of the circuit board.

Due to such a constitution, the first protrusions and the second protrusions are brought into contact with each other by way of the circuit board and hence, no twisting force acts on the circuit board thus effectively preventing the generation of unnecessary stress on the circuit board.

According to another aspect of the invention, in the branch connection box, the deflection prevention means is comprised of a plurality of protrusions integrally formed on the first case member and a plurality of protrusions integrally formed on the second case member, and the protrusions of the first case member and the protrusions of the second case member are brought into contact with each other by way of thorough holes formed in the circuit board.

Due to such a constitution, protrusions of the first case member and the protrusions of the second case member are brought into contact with each other by way of thorough holes formed in the circuit board and hence, even if the case is pressed toward the circuit board side, no unnecessary pressing force acts on the circuit board thus effectively preventing the deflection of the case.

In the branch connection box of the seventh aspect, the protrusions of the first case member and the protrusions of the second case member are formed such that both protrusions are brought into contact with each other at positions adjacent to portions where the connector terminals are fixedly secured to the circuit board.

Due to such a constitution, the protrusions of the first case member and the protrusions of the second case member are brought into contact with each other in a narrow range in open face directions of the first case member and the second case member and hence, the deflection of the case can be assuredly prevented.

### BRIEF DESCRIPTION OF THE DRAWINGS

Fig. is a longitudinal cross-sectional view of a branch connection box of an embodiment which does not show the present invention;
Fig. 2 is an exploded perspective view of the branch connection box shown in Fig. 1;
Fig. 3 is a longitudinal cross-sectional view of a branch connection box of the first embodiment of the present invention;
Fig. 4 is an exploded perspective view of the branch connection box shown in Fig. 3;
Fig. 5 is a longitudinal cross-sectional view of a branch connection box of the second embodiment of the present invention;
Fig. 6 is an exploded perspective view of the branch connection box shown in Fig. 5; and
Fig. 7 is a longitudinal cross-sectional view of a branch connection box of a prior art.

### DETAILED DESCRIPTION OF THE PREFERRED EMBODIMENTS

Now, a description will be given in more detail of preferred embodiments of the invention with reference to the accompanying drawings.

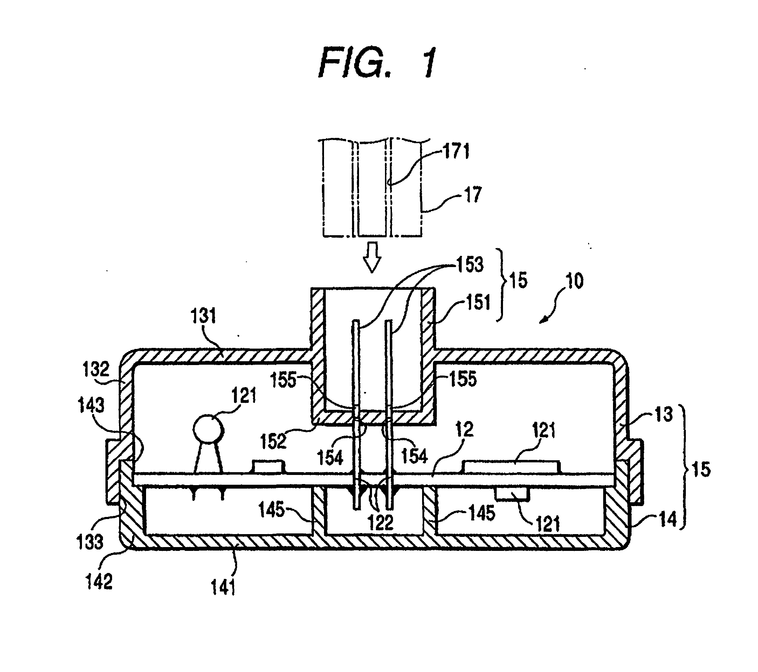

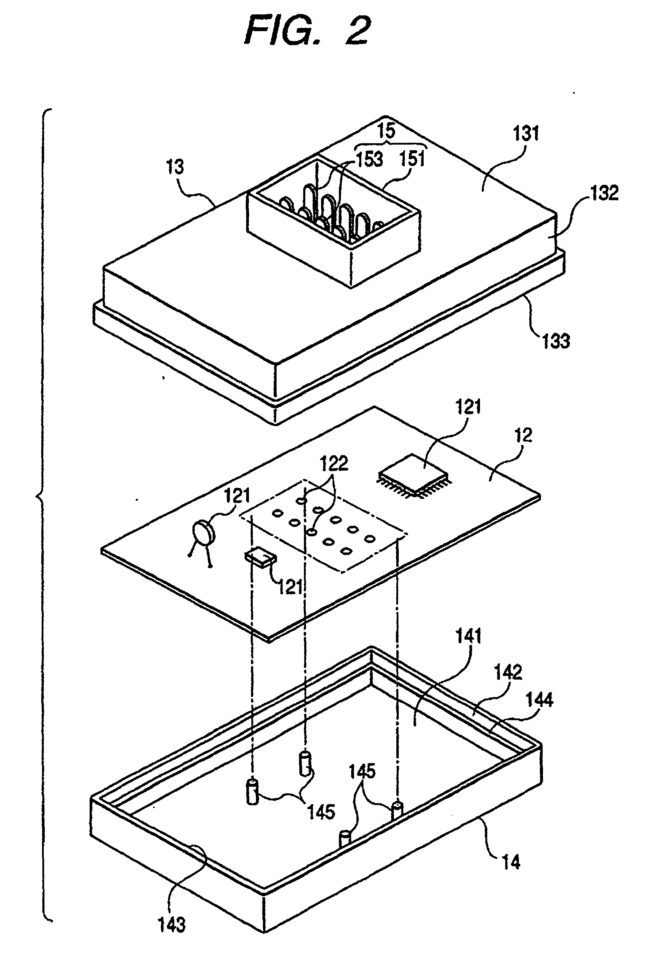

Fig. 1 is a cross-sectional view of a branch connection which does not correspond to the present invention and Fig. 2 is an exploded perspective view thereof. In these drawings, the branch connection box 10 includes a case 11 made of resilient material such as synthetic resin or the like and a circuit board 12 made of a resilient material such as synthetic resin or the like which is accommodated in the inside of the case 11.

The case 11 includes an upper case 13 and a lower case 14 and is constructed by combining them with each other with a fitting engagement under the condition that respective openings 133, 143 which will be explained later face each other in an opposed manner. The upper case 13 is comprised of a main wall 131 and a circumferential wall 132 which is integrally formed on the peripheral edge of the main wall 131 and an opening 133 is formed at the lower face of the upper case 13. A connector housing 151 is integrally formed on the main wall 131. Although the connector housing 151 is formed such that a bottom wall 152 thereof is recessed toward the opening 133 side, the bottom wall 152 may be formed on the same plane as the main wall 131. In both cases, the bottom wall 152 constitutes a portion of the main wall 131.

Further, a plurality of elongated male connector terminals 153 which are formed by punching a metal sheet or the like are fixedly secured to a bottom wall 152 (that is, the main wall 131) of the connector housing 151, wherein one end sides of the connector terminals 153 are positioned in the outside of the case 11 within the connector housing 151, while the other end sides of the connector terminals 153 are positioned in the inside of the case 11. The connector terminals 153 are fixedly secured to the bottom wall 152 by inserting the connector terminals 153 into through holes 154 which are formed in the bottom wall 152 and have a cross section slightly smaller than the transverse cross section of the connector terminals 153 or by other methods. Further, the connector terminals 153 are provided with widened flange portions 155 and positioning of the connector terminals 153 in an axial direction is carried out by inserting these flange portions 155 into the through holes 154 under pressure. With the provision of the connector housing 151 and the connector terminals 153, the connector 15 is integrally formed with the case 11.

The lower case 14 is comprised of a main wall 141 and a peripheral wall 142 which is integrally formed with the periphery of the main wall 141 and is provided with an opening 143 at an upper face thereof. A shoulder portion 144 for allowing the circuit board 12 to be placed thereon is formed on the inner periphery of the opening 143. On the main wall 141 in the lower case 14, a plurality (four in this embodiment) of rod-like protrusions 145 which extend to a position of the shoulder portion 144 and constitute deflection prevention means are integrally formed.

On the circuit board 12, given wiring conductors which are not shown in drawings are arranged and a plurality of chip-type or lead-line type electronic components 121 are mounted on the circuit board 12 such that they are connected to the wiring conductors by soldering or the like. The circuit board 12 is provided with a plurality of through holes 122 in which the other ends of the connector terminals 153 fixedly secured to the upper case 13 are inserted. Around respective through holes 122, lands which are connected to the wiring conductors although not shown in drawings are formed. The other ends of the connector terminals 153 which are inserted into the respective through holes 122 are fixedly secured to the respective lands by soldering or the like. A plurality of protrusions 145 which are described previously are formed at positions which surround a plurality of contact portions where respective connector terminals 153 are fixedly secured to the circuit board 12 and are adjacent to such portions.

The branch connection box 10 having such a constitution is assembled such that the other ends of the connector terminals 153 which are supported by the upper case 13 are made to pass through the through holes 122 of the circuit board 12 and are fixedly secured to the circuit board 12 by soldering or the like, then the opening 133 of the upper case 13 and the opening 143 of the lower case 14 are engaged with each other using a fitting engagement, and the upper case 13 and the lower case 14 are integrally joined by screws or a given engagement. Here, the circuit board 12 is brought into contact with the shoulder portion 144 of the lower case 14 and the protrusions 145 and hence, the circuit board 12 is brought into a fixed condition in the inside of the case 11.

According to the branch connection box 10 having the above-mentioned constitution, at the time of mounting the external connector 17 in the inside of the connector housing 151 and inserting a female connector terminal 171 into the male connector terminals 153 under pressure, even if the upper case 13 is pressed toward the circuit board 12 side, the circuit board 12 is brought into contact with the protrusions 145 formed on the lower case 14 and is not deflected and hence, no stress is generated at the portion where the connector terminals 153 are fixedly secured to the circuit board 12. Accordingly, problems such that cracks occur at the fixedly securing portions and the lands are peeled off thus giving rise to a disconnection can be eliminated. Further, problems such that the electrical connection of electrical components 121 mounted on the circuit board 12 with the circuit board 12 is disconnected and the electronic components 121 per se are ruptured can be eliminated.

Although, in this embodiment, the protrusions 145 are formed at the contact positions which are adjacent to the portions where the connector terminals 153 are fixedly secured to the circuit board 12, the protrusions 145 may be formed at positions a given distance away from such a fixedly securing portions. However, in case the protrusions 145 are formed at positions excessively away from the fixedly securing portions, the circuit board is liable to be deflected and hence, the allowable distance which can be shifted away from the fixedly securing portions is determined by the degree of deflection which depends on the kind of material and the thickness of the circuit board 12.

Further, in this embodiment, although the protrusions 145 are integrally formed with the lower case 14, the protrusions 145 may be individually formed of insulating material such as synthetic resin, ceramic or the like and thereafter may be fixedly secured to the lower case 14 by an adhesive or screw means. In any case, by integrally forming the protrusions 145 with the lower case 14, the protrusions 145 can have the given length and hence, the circuit board 12 can be assuredly brought into contact with the protrusions 145 thus effectively preventing the deflection of the circuit board 12.

Further, the protrusions 145 may be formed to have a length which makes the protrusions 145 slightly away from the circuit board 12 under the condition that the pressing force toward the circuit board 12 side is not yet applied to the upper case 13. In such a case, also, under the condition that the pressing force is applied to the upper case 13, the circuit board 12 is readily brought into contact with the protrusions 145 and hence, the deflection of the circuit board 12 can be effectively prevented.

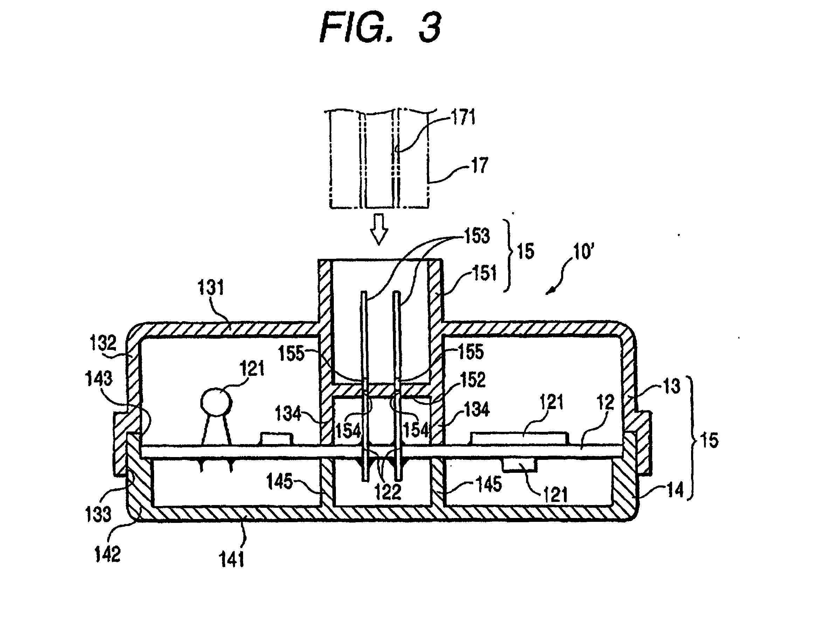

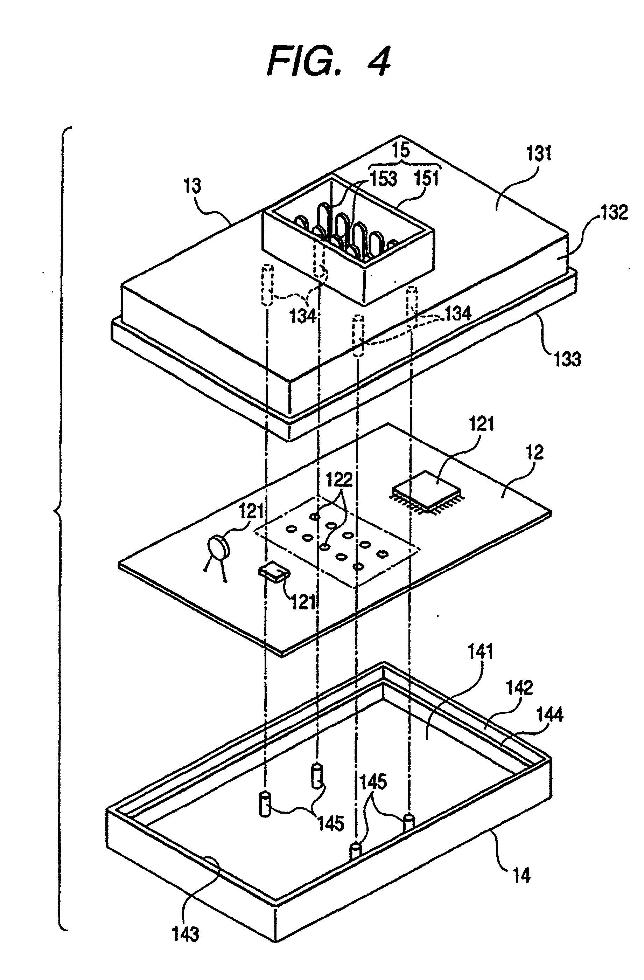

Fig. 3 is a longitudinal cross-sectional view of the branch connection box according to the first embodiment of the present invention and Fig. 4 is an exploded perspective view of the branch connection box. In these drawings, constituting parts which are equal to those parts of the Figures 1 and 2 are denoted by same reference numerals and hence, the detailed explanation thereof is omitted and the embodiment is explained hereinafter focusing on the points which are different from the first embodiment. That is, the branch connection box 10' according to the first embodiment includes a case 11 which is comprised of an upper case 13 and a lower case 14 and a circuit board 12 which is accommodated in the inside of the case 11 in a fixedly secured condition. On a bottom wall 152 (that is, a main wall 131) of a connector housing 151 disposed in the inside of the upper case 13 and at positions corresponding to respective protrusions 145 formed on the lower case 14 (hereinafter called first protrusions 145), a plurality (four in this embodiment) of rod-like second protrusions 134 which extend to positions where protrusions 134 are brought into contact with the circuit board 12 and constitute deflection prevention means are formed by an integral molding.

In the branch connection box 10' having such a constitution, even if the upper case 13 is pressed toward the circuit board 12 side at the time of inserting an external connector terminal 171 into the connector terminals 153 under pressure, the first protrusions 145 and the second protrusions 134 are brought into contact with each other by way of the circuit board 12 and hence, the deflection of the case can be prevented and accordingly the deflection of the circuit board 12 can be prevented. Therefore, no stress is generated at portions where the connector terminals 153 are fixedly secured to the circuit board 12 and hence, problems such that cracks occur at the fixedly securing portions and the lands are peeled off thus giving rise to a disconnection can be eliminated and further problems such that the electrical connection of the electronic components.121 mounted on the circuit board 12 with the circuit board 12 is disconnected and the electronic components 121 per se are ruptured can be eliminated.

In the branch connection box 10' having such a constitution, even if the upper case 13 is pulled in a direction away from the circuit board 12 at the time of pulling out the external connector terminal 171 from the connection terminals 153, the circuit board 12 is brought into contact with the second protrusions 134 and hence, the deflection of the circuit board 12 can be prevented and any inconveniences which give rise to due to the deflection of the circuit board 12 can be obviated.

Further, although the second protrusions 134 are formed at positions which correspond to the first protrusions 145 in this embodiment, the second protrusions 134 may be formed at positions shifted from the first protrusions 145 in a planar direction of the circuit board 12. Even in such a case, the second protrusions 134 are brought into contact with the circuit board 12 supported by the first protrusions 145 and hence, the deflection of the case is prevented and accordingly the circuit board 12 is not deflected. Further, although the first protrusions 145 and the second protrusions 134 are formed at the contact positions which are adjacent to the portions where the connector terminals 153 are fixedly secured to the circuit board 12, the protrusions 145, 134 may be formed at positions a given distance away from such fixedly securing portions. However, in case the protrusions 145, 134 are formed at positions excessively away from the fixedly securing portions, the circuit board 12 is liable to be deflected and hence, the allowable distance which can be shifted away from the fixedly securing portions is determined by the degree of deflection which depends on the kind of material and the thickness of the circuit board 12.

Further, in this embodiment, although the second protrusions 134 are integrally formed with the upper case 13, the second protrusions 134 may be individually formed of insulating material such as synthetic resin, ceramic or the like and thereafter may be fixedly secured to the upper case 13 by an adhesive or screw means. In any case, by integrally forming the protrusions 134 with the upper case 13, the second protrusions 134 can have the given length and hence, the second protrusions 134 can be assuredly brought into contact *with* the circuit board 12 thus effectively preventing the deflection of the case.

Further, the second protrusions 134 may be formed to have a length which shifts the protrusions 145 slightly away from the circuit board 12 under the condition that the pressing force toward the circuit board 12 side is not yet applied to the upper case 13. In such a case, also, under the condition that the pressing force is applied to the upper case 13, the circuit board 12 is readily brought into contact with the second protrusions 134 and hence, the deflection of the upper case 13 can be effectively prevented.

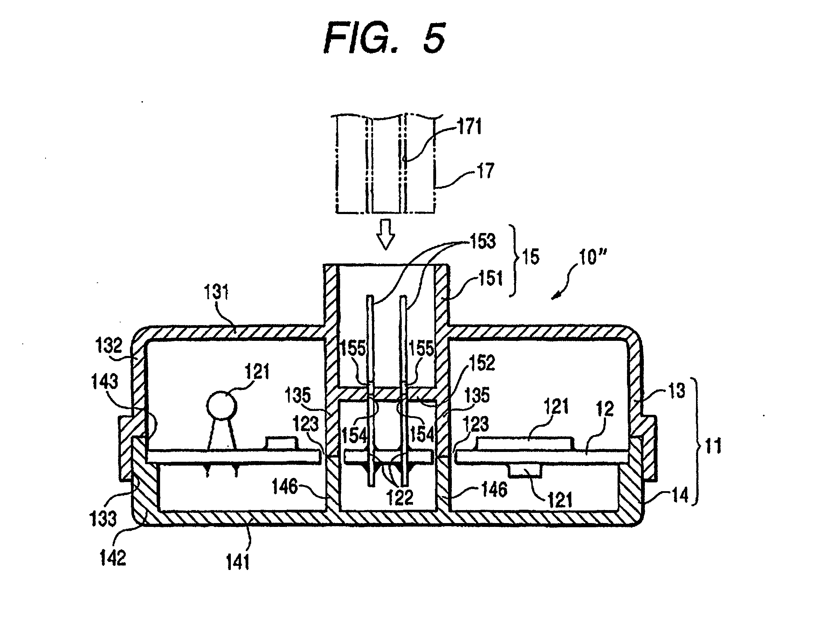

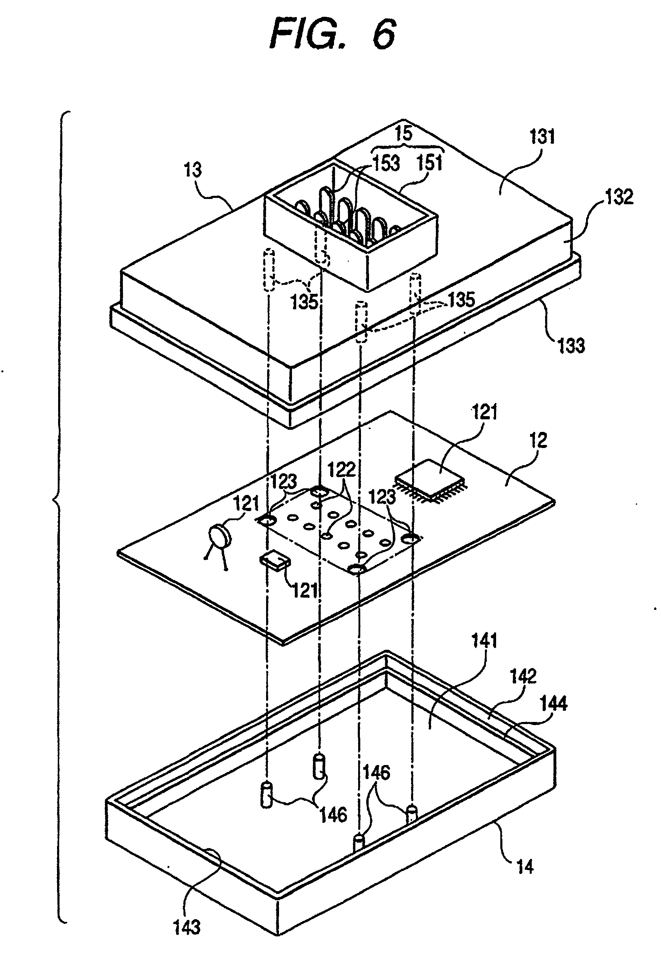

Fig. 5 is a longitudinal cross-sectional view of the branch connection box according to the second embodiment of the present invention and Fig. 6 is an exploded perspective view of the branch connection box. In these drawings, constituting parts which are equal to those parts of figures 1 and 2 are denoted by same reference numerals and hence, the detailed explanation thereof is omitted and the embodiment is explained hereinafter focusing on the points which are different from the first embodiment. That is, the branch connection box 10" according to the second embodiment includes a case 11 which is comprised of an upper case 13 and a lower case 14 and a circuit board 12 which is accommodated in the inside of the case 11 in a fixedly secured condition. In the inside of the upper case 13, a plurality (four in this embodiment) of rod-like protrusions 135 which extend to the circuit board 12 side and constitute the deflection prevention means are formed on a bottom wall 152 (that is, a main wall 131) of a connector housing 151 by an integral molding, while in the inside of the lower case 14, a plurality (four in this embodiment) of rod-like protrusions 146 which extend to the circuit board 12 side and constitute the deflection prevention means are formed at positions corresponding to the protrusions 135.

These protrusions 135, 146 are formed at contact positions which surround and are adjacent to a plurality of portions where connector terminals 153 are fixedly secured to the circuit board 12 and the protrusions 135, 146 are brought into contact with each other by way of a plurality of through holes 123 formed in the circuit board 12. The through holes 123 have a diameter larger than the transverse cross sections of the protrusions 135, 146 and hence, even if the position of the circuit board 12 is shifted or the like, the protrusions 135, 146 can be brought into contact with each other.

In the branch connection box 10" having such a constitution, even if the upper case 13 is pressed toward the circuit board 12 side at the time of inserting an external connector terminal 171 into the connector terminals 153 under pressure, both protrusions 135, 146 are brought into contact with each other by way of the through holes 123 of the circuit board 12 and hence, the deflection of the case can be prevented and accordingly the circuit board 12 is not deflected. Therefore, no stress is generated at portions where the connector terminals 153 are fixedly secured to the circuit board 12 and hence, problems such that cracks occur at the fixedly securing portions and the lands are peeled off thus giving rise to a disconnection can be eliminated and further problems such that the electrical connection of the electronic components mounted on the circuit board 12 with the circuit board 12 is disconnected and the electronic components per se are ruptured can be eliminated.

Although both protrusions 135 and 146 are formed at positions which are adjacent to portions where the connector terminals 153 are fixedly secured to the circuit board 12 in this embodiment, the protrusions 135 and 146 may be formed at positions shifted a given distance from such fixedly securing portions. However, in case the protrusions 135, 146 are formed at positions excessively away from the fixedly securing portions, the circuit board 12 is liable to be deflected and hence, the allowable distance which can be shifted away from the fixedly securing portions is determined by the degree of deflection which depends on the kind of material and the thickness of the circuit board 12.

Further, in this embodiment, although the protrusions 135 are integrally formed with the upper case 13 and the protrusions 146 are integrally formed with the lower case 14, the protrusions 135, 146 may be individually formed of insulating material such as synthetic resin, ceramic or the like and thereafter may be fixedly secured to the upper case 13 and the lower case 14 by an adhesive or screw means. In any case, by integrally forming the protrusions 135, 146 with the upper case 13 and the lower case 14, the protrusions 135, 146 can have the given length and hence, both protrusions 135, 146 can be assuredly brought into contact with the circuit board 12 thus the deflection of the case can be effectively prevented.

Further, both protrusions 135 and 146 may be formed to have a length which makes the protrusions 135 and 146 slightly away from the circuit board 12 under the condition that the pressing force toward the circuit board 12 side is not yet applied to the upper case 13. In such a case, also, under the condition that the pressing force is applied to the upper case 13, the circuit board 12 is readily brought into contact with both protrusions 135, 146 and hence, the deflection of the upper case 13 can be effectively prevented.

Further, although, in any one of the above-mentioned embodiments, the connector terminals 153 fixedly mounted on the upper case 13 are of a male type, the connector terminals 153 may be of a female type. In this case, the connector terminal 171 of the external connector 17 becomes a male type. Further, although, in any one of the above-mentioned embodiments, the upper case 13 and the lower case 14 are formed in recesses having openings, either one of them may adopt a plate-like shape. What is important is that the case is constructed by combining the upper case 13 and the lower case 14. Further, in the above-mentioned embodiment, although any one of the protrusions 134, 135, 146, 145 are made of four rod-like protrusions, the shape and the number of the protrusions can be arbitrarily determined. Further, the branch connection box of the present invention can be also used as a junction box of an automobile which accommodates a bus bar board or the like in the case 11.

## Claims

1. A branch connection box, comprising:
a case comprising two case members (13, 14) in which a circuit board (12) is fixedly accommodated;
a plurality of connector terminals (153, 154) fixedly mounted to said case, said connector terminals (153, 154) having respective one ends thereof positioned outside said case (13, 14) and respective other ends thereof disposed inside said case (13, 14), said respective other ends of said connector terminals (153, 154) being fixedly secured to the circuit board (12), and
deflection prevention means (34, 145) for preventing the deflection of said case (13, 14) generated upon inserting an external connector terminal (17) into said connector terminals (153, 154) under pressure, said deflection prevention means being integrally formed with said case (13, 14), **characterized in that**
said deflection prevention means includes a plurality of second protrusions (134) formed on the first case member (13) such that said second protrusions (134) are brought into contact with one surface of said circuit board (12) in addition to a plurality of first protrusions (145) formed on the second case member (14), whereby said first protrusion (145) are brought into contact with the other surface of the circuit board (12).

2. A branch connection box according to claim 1, wherein said connector terminals (153, 154) are fixedly mounted on said first case member (13), said circuit board (12) is accommodated in said case such that one surface of said circuit board (12) faces said first case member (13) in an opposed manner and the other surface of said circuit board (12) faces said second case member (14) in an opposed manner.

3. A branch connection box according to claim 2, wherein a plurality of said first and second protrusions (145, 134) are formed such that said protrusions (145, 134) are brought into contact with said circuit board (12) at positions adjacent to portions where said connector terminals (153, 154) are fixedly secured to said circuit board (12).

4. A branch connection box according to claim 1, wherein a plurality of said second protrusions (134) are formed such that said second protrusions (134) respectively face a plurality of said first protrusions (145) in an opposed manner by way of said circuit board (12).

5. A branch connection box, comprising:
a case comprising two case members (13, 14) in which a circuit board (12) is fixedly accommodated;
a plurality of connector terminals (153, 154) fixedly mounted to said case, said connector terminals (153, 154) having respective one ends thereof positioned outside said case (13, 14) and respective other ends thereof disposed inside said case (13, 14), said respective other ends of said connector terminals (153, 154) being fixedly secured to the circuit board (12), and
deflection prevention means (135, 146) for preventing the deflection of said case (13, 14) generated upon inserting an external connector terminal (17) into said
connector terminals (153, 154) under pressure, said deflection prevention means being integrally formed with said case (13, 14), **characterized in that**
said deflection prevention means comprises a plurality of protrusions (135) integrally formed on said first case member (13) and a plurality of protrusions (146) integrally formed on said second case member (14), and said protrusions (135) of said first case member (13) and said protrusions (146) of said second case member (14) are brought into contact with each other by way of through holes (123) formed in said circuit board (12).

6. A branch connection box according to claim 6, wherein said protrusions (135) of said first case member (13) and said protrusions (146) of said second case member (14) are formed such that both protrusions (135, 146) are brought into contact with each other at positions adjacent to portions where said connector terminals (153, 154) are fixedly secured to said circuit board (12).

## Patentansprüche

1. Abzweigverbinderkasten, der aufweist:
ein Gehäuse mit zwei Gehäuseelementen (13, 14), in dem eine Schaltungskarte (12) befestigt ist;
mehrere Verbindungsanschlüsse (153, 154), die fest am Gehäuse angebracht sind, wobei jeweils ein Ende der Verbindungsanschlüsse (153, 154) außerhalb des Gehäuses (13, 14) und ein jeweiliges andere Ende innerhalb des Gehäuses (13, 14) angeordnet ist, wobei die jeweiligen anderen Enden der Verbindungsanschlüsse (153, 154) an der Schaltungskarte (12) befestigt sind, und
eine Durchbiegungsverhinderungseinrichtung (34, 145) zur Verhinderung der Durchbiegung des Gehäuses (13, 14), die durch das Einführen eines äußeren Verbindungsanschlusses (17) in die Verbindungsanschlüsse (153, 154) unter Druck erzeugt wird, wobei die Durchbiegungsverhinderungseinrichtung einstückig mit dem Gehäuse (13, 14) ausgebildet ist,
**dadurch gekennzeichnet, daß**
die Durchbiegungsverhinderungseinrichtung mehrere zweite Vorsprünge (134) enthält, die am ersten Gehäuseelement (13) ausgebildet sind, so daß die zweiten Vorsprünge (134) zusätzlich zu mehreren ersten Vorsprüngen (145), die auf dem zweiten Gehäuseelement (14) ausgebildet sind, mit einer Oberfläche der Schaltungskarte (12) in Kontakt gebracht werden, wobei die ersten Vorsprünge (154) mit der anderen Oberfläche der Schaltungskarte (12) in Kontakt gebracht werden.

2. Abzweigverbinderkasten nach Anspruch 1, wobei die Verbindungsanschlüsse (153, 154) im ersten Gehäuseelement (13) befestigt sind, wobei die Schaltungskarte (12) so im Gehäuse angebracht ist, daß eine Oberfläche der Schaltungskarte (12) dem ersten Gehäuseelement (13) gegenüberliegt und die andere Oberfläche der Schaltungskarte (12) dem zweiten Gehäuseelement (14) gegenüberliegt.

3. Abzweigverbinderkasten nach Anspruch 2, wobei mehrere erste und zweite Vorsprünge (145, 134) so ausgebildet sind, daß die Vorsprünge (145, 134) an Positionen in Kontakt mit der Schaltungskarte (12) gebracht werden, die benachbart zu Abschnitten sind, an denen die Verbindungsanschlüsse (153, 154) an der Schaltungskarte (12) befestigt sind.

4. Abzweigverbinderkasten nach Anspruch 1, wobei mehrere zweite Vorsprünge (134) so ausgebildet sind, daß die zweiten Vorsprünge (134) jeweils mehreren ersten Vorsprüngen (145) mit der dazwischen angeordneten Schaltungskarte (12) gegenüberliegen.

5. Abzweigverbinderkasten, der aufweist:
ein Gehäuse mit zwei Gehäuseelementen (13, 14), in dem eine Schaltungskarte (12) befestigt ist,
mehrere Verbindungsanschlüsse (153, 154), die fest am Gehäuse angebracht sind, wobei ein jeweiliges Ende der Verbindungsanschlüsse (153, 154) außerhalb des Gehäuses (13, 14) und ein jeweiliges andere Enden innerhalb des Gehäuses (13, 14) angeordnet ist, wobei die jeweiligen anderen Enden der Verbindungsanschlüsse (153, 154) an der Schaltungskarte (12) befestigt sind, und
eine Durchbiegungsverhinderungseinrichtung (135, 146) zur Verhinderung der Durchbiegung des Gehäuses (13, 14), die durch das Einführen eines äußeren Verbindungsanschlusses (17) in die Verbindungsanschlüsse (153, 154) unter Druck erzeugt wird, wobei die Druchbiegungsverhinderungseinrichtung einstückig mit dem Gehäuse (13, 14) ausgebildet ist,
**dadurch gekennzeichnet, daß**
die Durchbiegungsverhinderungseinrichtung mehrere Vorsprünge (135), die einstückig auf dem ersten Gehäuseelement (13) ausgebildet sind, und mehrere Vorsprünge (146), die einstückig auf dem zweiten Gehäuseelement (14) ausgebildet sind, aufweist, und die Vorsprünge (135) des ersten Gehäuseelementes (13) und die Vorsprünge (146) des zweiten Gehäuseelementes (14) jeweils durch in der Schaltungskarte (12) ausgebildete Löcher (123) in Kontakt gebracht werden.

6. Abzweigverbinderkasten nach Anspruch 5, wobei die Vorsprünge (135) des ersten Gehäuseelementes (13) und die Vorsprünge (146) des zweiten Gehäuseelementes (14) so ausgebildet sind, daß die beiden Vorsprünge (135, 146) an Positionen in Kontakt gebracht werden, die benachbart zu Abschnitten sind, an denen die Verbindungsanschlüsse (153, 154) an der Schaltungskarte (12) befestigt sind.

## Revendications

1. Boîte de connexion comprenant :
un boîtier constitué de deux éléments de boîtier (13, 14) dans lequel une plaquette de circuit (12) est reçue de façon fixe ;
une pluralité de bornes de connecteur (153, 154) montées de façon fixe dans ledit boîtier, lesdites bornes de connecteur (153, 154) ayant des premières extrémités respectives disposées à l'extérieur dudit boîtier (13, 14) et leurs autres extrémités respectives disposées à l'intérieur dudit boîtier (13, 14), lesdites autres extrémités desdites bornes de connecteur (153, 154) étant fixées à demeure à la plaquette de circuit (12), et
des moyens évitant une déviation (34, 145) afin d'éviter la déviation dudit boîtier (13, 14) générée lors de l'introduction d'une borne de connecteur extérieure (17) dans lesdites bornes de connecteur (153, 154) sous pression, lesdits moyens évitant une déviation faisant corps avec ledit boîtier (13, 14), **caractérisé en ce que** lesdits moyens afin d'éviter une déviation comprennent une pluralité de secondes parties saillantes (134) formées sur ledit premier élément de boîtier (13) de telle sorte que lesdites secondes parties saillantes (134) soient amenées en contact d'une surface de ladite plaquette de circuit (12) en plus d'une pluralité de premières parties saillantes (145) formées sur le second élément de boîtier (14) de telle sorte que lesdites premières parties saillantes (145) soient amenées en contact de l'autre surface de la plaquette de circuit (12).

2. Boîte de connexion selon la revendication 1, dans laquelle lesdites bornes de connecteur (153, 154) sont montées de façon fixe sur ledit premier élément de boîtier (13), ladite plaquette de circuit (12) est reçue dans ledit boîtier de telle sorte qu'une surface de ladite plaquette de circuit (12) se trouve en face dudit premier élément de boîtier (13) d'une manière en vis-à-vis et l'autre surface de ladite plaquette de circuit (12) se trouve en face dudit second élément de boîtier (14) d'une manière en vis-à-vis.

3. Boîte de connexion selon la revendication 2, dans laquelle une pluralité desdites premières et secondes parties saillantes (145, 134) sont formées de telle sorte que lesdites parties saillantes (145, 134) soient amenées en contact de ladite plaquette de circuit (12) en des positions adjacentes à des parties où lesdites bornes de connecteur (153, 154) sont fixées à demeure à ladite plaquette de circuit (12).

4. Boîte de connexion selon la revendication 1, dans laquelle une pluralité desdites secondes parties saillantes (134) sont formées de telle sorte que lesdites secondes parties saillantes (134) se trouvent respectivement en face d'une pluralité desdites premières parties saillantes (145) d'une manière opposée à l'aide de ladite plaquette de circuit (12).

5. Boîte de connexion comprenant :
un boîtier comprenant deux éléments de boîtier (13, 14) dans lequel une plaquette de circuit (12) est reçue de façon fixe ;
une pluralité de bornes de connecteur (153, 154) montées de façon fixe dans ledit boîtier, lesdites bornes de connecteur (153, 154) ayant leurs premières extrémités respectives disposées à l'extérieur dudit boîtier (13, 14) et leurs autres extrémités respectives disposées à l'intérieur dudit boîtier (13, 14), lesdites secondes extrémités respectives desdites bornes de connecteur (153, 154) étant fixées à demeure sur ladite plaquette de circuit (12), et
des moyens évitant une déviation (135, 146) afin d'éviter la déviation dudit boîtier (13, 14) générée lors de l'introduction d'une borne de connecteur extérieure (17) dans lesdites bornes de connecteur (153, 154) sous pression, lesdits moyens évitant une déviation faisant corps avec ledit boîtier (13, 14), **caractérisé en ce que**
lesdits moyens évitant une déviation comportent une pluralité de parties saillantes (135) faisant corps avec ledit premier élément de boîtier (13) et une pluralité de parties saillantes (146) faisant corps avec ledit second élément de boîtier (14), et lesdites parties saillantes (135) dudit premier élément de boîtier (13) et lesdites parties saillantes (146) dudit second élément de boîtier (14) sont amenées en contact l'une de l'autre à l'aide de trous traversants (123) pratiqués dans ladite plaquette de circuit (12).

6. Boîte de connexion selon la revendication 6, dans laquelle lesdites parties saillantes (135) dudit premier élément de boîtier (13) et lesdites parties saillantes (146) dudit second élément de boîtier (14) sont formées de telle sorte que les deux parties saillantes (135, 146) sont amenées en contact l'une de l'autre en des positions adjacentes à des parties où lesdites bornes de connecteur (153, 154) sont fixées à demeure à ladite plaquette de circuit (12).
